# EUROPÄISCHE PATENTANMELDUNG

(11) **EP 2 498 300 A1**
(43) Veröffentlichungstag der Anmeldung: **12.09.2012**
(21) Anmeldenummer: 11157562.7
(22) Anmeldetag: 09.03.2011
(51) Int. Cl.: H01L 31/042

(54) **Photovoltaikanlage, Steuereinrichtung und Schaltvorrichtung**

(71) Anmelder: SIEMENS AKTIENGESELLSCHAFT, 80333 München (DE)
(72) Erfinder: Körber, Nils, 91056, Erlangen (DE)

(57) **Zusammenfassung**

In einer Photovoltaikanlage (1) mit mindestens einer Reihenschaltung von Solarzellen (2), wird erfindungsgemäß in kleinere Gruppen aus Solarzellen aufgeteilt, so dass an jeder Gruppe höchstens eine ungefährliche Kleinspannung anliegt. Jede solche Gruppe, üblicherweise je ein Solarmodul (11,12,13,14,15,16), ist über eine Abschaltvorrichtung (21,22,23,24,25,26) mit der Reihenschaltung von Solarzellen (2) verbunden. Jede Abschaltvorrichtung enthält ein Schaltmittel (35), das derart ausgelegt ist, dass eine vorgegebene oder vorgebbare An- oder Abschaltung der Solarzellengruppe erfolgen kann. Ferner kann zu jedem dieser Schaltmittel (35) ein Mittel zur Brückung (37) vorhanden sein, welches derart ausgelegt ist, dass während der Abschaltung der Gruppe eine Verbindung zwischen den in der Reihenschaltung (2) verbleibenden Solarzellen bestehen bleibt.

Auf diese Weise können, z.B. für Wartungszwecke, einzelne oder mehrere Solarzellengruppen gezielt aus der Reihenschaltung (2) herausgenommen werden.

Auf diese Weise können außerdem, z.B. für den Brandfall als "Feuerwehrschalter", alle Solarzellengruppen aus der Reihenschaltung (2) herausgenommen werden. In diesem Fall ist die Reihenschaltung (2) komplett spannungsfrei.

Es wird ferner eine Steuereinrichtung (40) und Schaltvorrichtung (30a, 30b) angegeben.

## Beschreibung

Die Erfindung betrifft eine Photovoltaikanlage mit mindestens einer Reihenschaltung von Solarzellen. Die Erfindung betrifft weiterhin eine Steuereinrichtung und eine passende Schaltvorrichtung.

Photovoltaik-Solaranlagen bestehen im Prinzip aus zusammen geschalteten Solarzellen sowie einem Stromwandler. Handelt es sich um eine netzgekoppelte Anlage, wird mit Hilfe eines Wechselrichters der in den Solarzellen entstehende Gleichstrom in Wechselstrom gewandelt und ins Stromnetz eingespeist. Bei der Netzeinspeisung in ein 230 V-Netz sind Stromwandler bzw. Wechselrichter üblicherweise im sog. Netzeinspeisegerät (NEG) untergebracht ist. Nach den geltenden Richtlinien ist vor dem Netzeinspeisegerät noch eine Gleichstrom-Freischaltstelle erforderlich, welche dazu vorgesehen ist, den in der Photovoltaikanlage produzierten Gleichstrom abzuschalten, beispielsweise um Arbeiten am Wechselrichter vorzunehmen. Die Gleichstrom-Freischaltstelle kann als DC-Schalter oder als Trennklemme realisiert sein und wird von den Herstellern häufig mit im Netzeinspeisegerät integriert.

Für den effizienten Betrieb ist eine Mindest-Eingangsspannung am Stromwandler notwendig, deshalb müssen viele Solarzellen in Reihe geschaltet werden. Die Zusammenschaltung der Solarzellen ist dabei üblicherweise derart realisiert, dass eine bestimmte Anzahl von Solarzellen zu einem Solarmodul zusammengefasst wird. Mehrere in Reihe geschaltete Solarzellen eines Moduls werden als Modulstrang oder Modulstring bezeichnet. Die Reihenschaltung mehrerer Solarmodule wird dann als Strang oder String bezeichnet.

Ein Problem bei Photovoltaikanlagen besteht darin, dass die Solarmodule selbst sowie die Leitungen bis zur Freischaltstelle vor dem Wechselrichter tagsüber immer unter Spannung stehen. Schließlich produzieren die Solarzellen stets Strom, sobald Licht darauf fällt. Dabei addieren sich die Modulspannungen häufig zu Strangspannungen von bis zu 1000V. Damit besteht im Brandfall und im Wartungsfall die Gefahr von Stromschlägen, die durch die Gleichstrom-Freischaltstelle (DC-Schalter) vor dem Wechselrichter nur zum Teil gebannt werden kann. Eine Beispielrechnung (überschlägig) soll dies verdeutlichen: Ein Modul des Typs MONO 185 der Firma Schott hat bei Standardmessbedingungen (STC) rund 45 V Leerlaufspannung. Die Reihenschaltung von nur 6 Solarmodulen sorgt dann bis zum DC-Schalter der Freischaltstelle schon für Spannungen von bis zu 270V, welche lebensgefährlich sind.

Als Konsequenz daraus können sich im Brandfall Einschränkungen bei den Rettungs- und Löscharbeiten ergeben, da die Feuerwehrleute den Eigenschutz beachten müssen. Im Extremfall ist ein Löschen gar nicht möglich, denn gemäß der Unfallverhütungsvorschrift dürfen nicht spannungsfrei geschaltete Gebäude nicht zum Innenangriff betreten werden. Ein ähnliches Problem wie im Brandfall stellt sich bei Wartung, Fehlersuche und Reparatur: Es muss immer unter hohen Spannungen gearbeitet werden.

Das beschriebene Problem wird in der Regel dadurch gelöst, dass entweder keine besondere Vorkehrung getroffen wird und man die Risiken in Kauf nimmt, oder dass als Vorkehrung für den Brandfall ein zusätzlicher DC-Schalter eingesetzt wird. Ein solcher sog. "Feuerwehrschalter" wurde auf der Intersolar 2010 von der Firma Eaton Corporation (www.eaton.com) erstmals vorgestellt. Durch Einsatz eines zusätzlichen DC-Schalters kann der örtliche Bereich, in dem noch gefährliche Hochspannung anliegen kann, verkleinert werden. Eine überall wirksame Reduzierung auf ungefährliche Spannungen wird mit einem solchen DC-Schalter aber nicht erreicht. Ist so ein DC-Schalter z.B. unter dem Dachvorsprung montiert, verbleibt als Gefahrenbereich immer noch die gesamte Dachfläche unter und rund um die montierten Solarmodule.

Es ist daher die Aufgabe der vorliegenden Erfindung, eine Photovoltaikanlage anzugeben, die derart ausgelegt ist, dass eine Aufteilung der einzelnen Stränge in kleinere elektrische Einheiten erreicht wird, so dass an jeder Einheit höchstens eine ungefährliche Kleinspannung anliegt. Es ist ferner die Aufgabe der Erfindung, eine Steuereinrichtung und eine Schaltvorrichtung für eine Photovoltaikanlage anzugeben, mittels welcher die Aufteilung des Stranges bewirkt werden kann.

Die erste Aufgabe wird durch die im kennzeichnenden Teil des Anspruchs 1 angegebenen Merkmale gelöst. Die weitere Aufgabe wird erfindungsgemäß durch eine Steuereinrichtung gemäß einem der Ansprüche 7 bis 11 und eine Schaltvorrichtung gemäß Anspruch 12 gelöst.

Eine Photovoltaikanlage mit mindestens einem Strang oder einer Reihenschaltung von Solarzellen weist erfindungsgemäß jeweils für eine Gruppe von Solarzellen ein Schaltmittel auf, das derart ausgelegt ist, dass eine vorgegebene oder vorgebbare An- oder Abschaltung der Gruppe erfolgen kann. Dadurch ist eine Aufteilung des Stranges in kleinere elektrische Einheiten in Form von Gruppen von Solarzellen möglich, so dass an jeder Gruppe höchstens eine ungefährliche Kleinspannung anliegt. In der praktischen Ausführung wird eine Gruppe von Solarzellen in der Regel ein Solarmodul sein, da dieses die handelsübliche Bauform darstellt.

In einer ersten Ausführungsvariante der Erfindung ist das Schaltmittel, mit welchem eine Abschaltung einer Gruppe von Solarzellen aus einem Strang erreicht wird, steuerbar ausgelegt. Durch eine Steuerung des Schaltmittels kann die Abschaltung nun für verschiedene Anwendungsfälle benutzt werden.

Vorteilhaft ist das steuerbare Schaltmittel als mechanischer, elektromagnetischer oder elektronisch betätigter Schalter ausgelegt. Dies bedeutet, dass eine Abschaltung mit den gewünschten Eigenschaften schon mit einem geeigneten handelsüblichen Bauelement wie z. B. einem Relais, einem Schütz oder Halbleiterbauelementen oder einer Kombination aus allen Varianten möglich ist.

Während im Brandfall eine einfache Aufteilung der Reihenschaltung in kleinere Gruppen ausreicht, um die Gesamtspannung wie beabsichtigt zu reduzieren, sollen im Wartungsfall einzelne Gruppen aus dem Betrieb genommen werden können. Trennt man dabei eine Gruppe von Solarzellen vom Strang, können an den vorherigen Strang-Anschlusspunkten trotzdem hohe Spannungen anliegen. Um dies zu vermeiden, ist zu jedem der Schaltmittel ein Mittel zur Brückung vorhanden, welches derart ausgelegt ist, dass während der Abschaltung der Gruppe eine Verbindung zwischen den in der Reihenschaltung verbleibenden Solarzellengruppen besteht. Ein weiterer Vorteil der Brückung ist, dass diese anderen Gruppen voll funktionsfähig bleiben und so z.B. Vergleichsmessungen am (Rest-)Strang möglich sind.

Für den Wartungsfall besonders vorteilhaft, da besonders sicher, bei Abschaltung die Verbindung zwischen den in der Reihenschaltung verbleibenden Solarzellen **unterbrechungsfrei** herzustellen. Hierdurch wird zusätzlich das Auftreten von hohen Spannungen auch schon während des Schaltvorganges vermieden.

Um eine unterbrechungsfreie Verbindung zu gewährleisten, wird als Mittel zur Brückung ein Halbleiter-Bauelement wie beispielsweise eine Diode verwendet. Auch hier zeigt sich die Einfachheit der erfindungsgemäßen Lösung. Durch diese Art der Brückung werden auch Lichtbogeneffekte wirkungsvoll reduziert. Deshalb empfiehlt sich die Brückung mit Halbleiter-Bauelement nicht nur für die Abschaltung im Wartungsfall, sondern auch für die Abschaltung im Brandfall.

Durch eine Zusammenfassung des Schaltmittels mit dem Mittel zur Brückung wird vorteilhaft eine kompakte Vorrichtung zur sicheren Abschaltung erreicht, die einfach zu implementieren ist.

Weitere vorteilhafte Ausgestaltungen der Erfindung betreffen Steuereinrichtungen zur Erreichung der Abschaltung aller oder einzelner Solarzellengruppen.

Zum Einen kann eine zentrale Steuerung für einige oder alle Gruppen von Solarzellen und deren Schaltmittel vorgesehen sein, z.B. in einer Schaltzentrale.

Zum Anderen kann eine dezentrale Steuerung pro Solarzellengruppe und Schaltmittel vorgesehen sein, z.B. für Wartungszwecke auf dem Dach. Dass die Erfindung beide Steuervarianten abdeckt, führt zu maximaler Flexibilität bei der Anwendung.

Neben der offensichtlichen Möglichkeit, per Wartungs- oder Notfallschalter von Hand zu steuern, ist auch die Kombination mit einer Sensorik möglich. Für den Brandfall wäre beispielsweise das Einschleifen einer oder mehrerer Temperatursicherungen in die Verbindung zwischen Stromversorgung und Abschaltvorrichtungen zweckmäßig. Diese Sicherungen unterbrechen bei Übertemperatur den Versorgungsstromkreis und sorgen so für die Abschaltung.

Die Erfindung wird nachfolgend anhand von in den Zeichnungen dargestellten Ausführungsbeispielen näher erläutert.

Es zeigen:
- Fig. 1: einen prinzipiellen Aufbau einer Photovoltaikanlage für die Netzeinspeisung (Stand der Technik)

- Fig. 2: ein Ausführungsbeispiel einer Photovoltaikanlage für die Netzeinspeisung, mit jeweils einer zusätzlichen Abschaltvorrichtung pro Solarzellengruppe (Solarmodul)
- Fig. 3: ein erstes Ausführungsbeispiel einer Vorrichtung zur sicheren Abschaltung eines Solarmoduls
- Fig. 4: ein zweites Ausführungsbeispiel einer Vorrichtung zur sicheren Abschaltung eines Solarmoduls
- Fig. 5: ein prinzipieller Aufbau einer Steuereinrichtung für Wartung und Fehlersuche

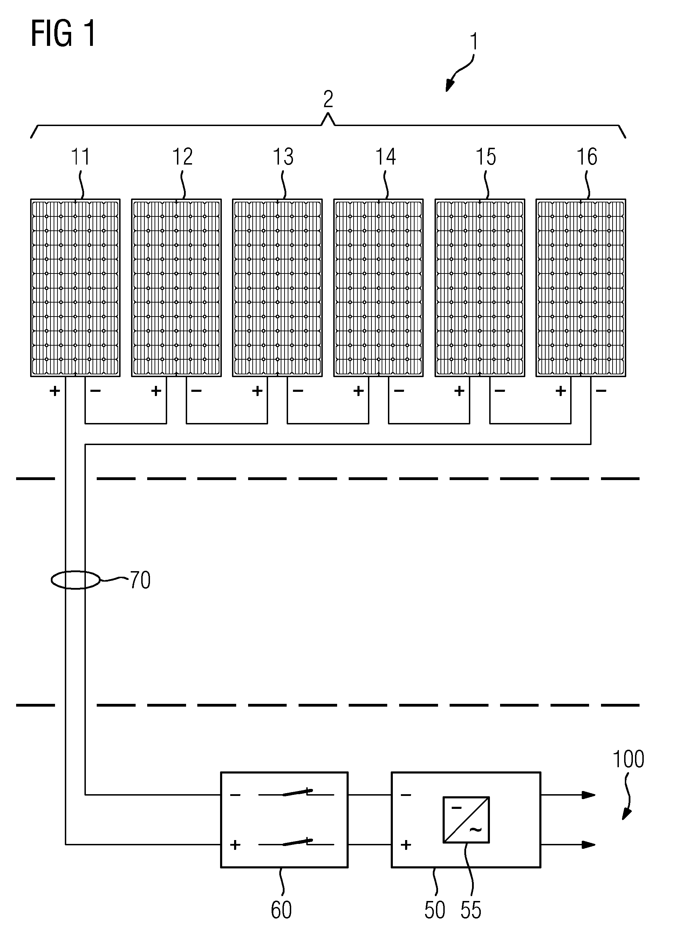

Figur 1 zeigt in einer Skizze den prinzipiellen Aufbau einer Photovoltaikanlage mit Netzeinspeisung. Eine mit 1 bezeichnete Photovoltaikanlage umfasst eine Reihenschaltung 2 aus sechs üblicherweise auf einem Gebäudedach angebrachten Solarmodulen 11 bis 16 zur Generierung elektrischer Energie aus der Sonnenenergie. Die Reihenschaltung mehrerer Solarmodule wird üblicherweise als Strang oder String bezeichnet. Jedes Solarmodul selbst weist ebenfalls eine Reihenschaltung aus einer Vielzahl von gleich ausgerichteten Solarzellen auf, welche manchmal als Modulstrang bezeichnet wird. Die interne Verschaltung der einzelnen Solarmodule ist nicht dargestellt. Die Solarmodule 16 und 11 sind über eine Gleichstrom-Freischaltstelle (DC-Schalter) 60 mit einem Netzeinspeisegerät 50 verbunden, welches als Stromwandler einen Wechselrichter 55 enthält, in welchem der in den Solarmodulen generierte Gleichstrom in Wechselstrom umgewandelt wird und ins Stromnetz 100 eingespeist wird. Die Freischaltstelle 60 und das Netzeinspeisegerät 50 sind hierbei häufig außerhalb des Dachbereichs eines Gebäudes und in der Nähe des Haus-Stromzählers, z.B. im Keller, angebracht. Die unterschiedlichen Gebäudeteile sind in Fig. 1 durch die gestrichelten Linien angedeutet. Die Leitungen 70, welche die Solarmodule 11 bis 16 mit der Freischaltstelle 60 verbinden stehen zumeist unter hohen Spannungen.

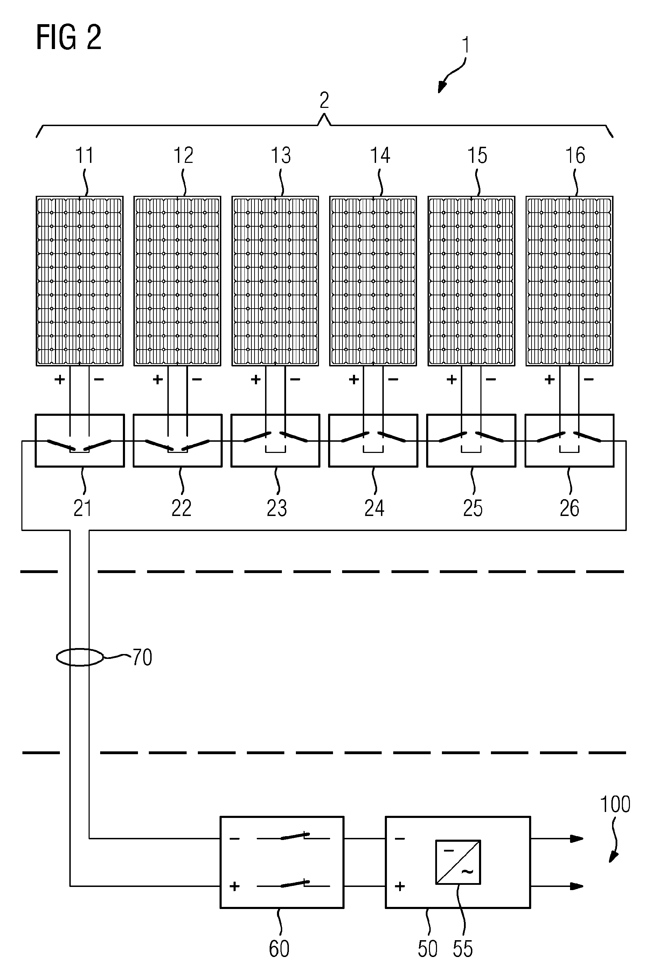

Figur 2 zeigt ein erstes Ausführungsbeispiel der Erfindung. Dargestellt ist die Photovoltaikanlage aus Figur 1, ergänzt um jeweils eine Schaltvorrichtung zur sicheren Abschaltung 21 bis 26 pro Solarzellengruppe (Modul) 11 bis 16.

Die mit 1 bezeichnete Photovoltaikanlage umfasst wieder eine Reihenschaltung 2 aus sechs Solarmodulen 11 bis 16 zur Generierung elektrischer Energie aus der Sonnenenergie. Allerdings sind die Solarmodule nicht direkt, sondern jeweils über eine der Abschaltvorrichtungen 21 bis 26 zu der Reihenschaltung 2 verbunden. In der gezeigten Beispielkonstellation sind die Module 11 durch die Abschaltvorrichtung 21 und Modul 12 durch Abschaltvorrichtung 22 aus dem Strang (hier gleich der Reihenschaltung) herausgenommen, während die Module 13 bis 16 durch die Abschaltvorrichtungen 23 bis 26 in den Strang geschaltet sind. In den Abschaltvorrichtungen 21 und 22 sind Ein- aus Ausgang jeweils gebrückt, so dass es durch die Abschaltung der Module keine Lücken im Strang gibt. Damit werden mögliche hohe Spannungen an solchen Lücken vermieden. Durch das Abschalten der Module 11 und 12 können an diesen ohne Gefahr Wartungsarbeiten vorgenommen werden, da nur noch jeweils die Modul-Leerlaufspannung anliegt, z.B. bei einem Modul des Typs MONO 185 der Firma Schott unter Standardmessbedingungen (STC) rund 45 V. Auch im Bereich der anderen Leitungen 70 ist die Spannung bereits entsprechend reduziert. Werden alle Module ausgeschaltet, wie es im Brandfall geschehen müsste, wäre der Bereich 70 komplett spannungsfrei. Damit wäre der Innenangriff, also Löscharbeiten im Haus, gefahrlos möglich. Auf dem Dach wären Spannungen von höchstens der Modul-Leerlaufspannung zu erwarten, sodass ein Feuerwehrmann problemlos das Dach betreten kann und bei Kontakt mit den Leitungen keinen gefährlichen Stromschlag erhält.

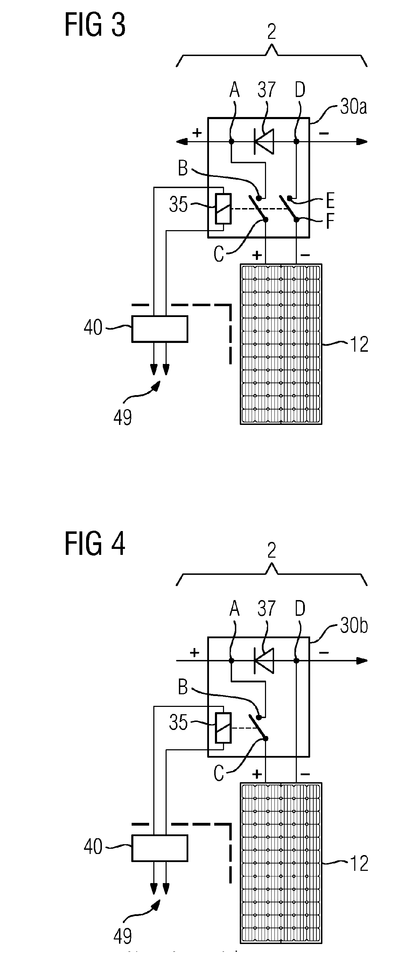

Figur 3 zeigt ein erstes konkretes Ausführungsbeispiel einer Schaltvorrichtung 30a zur sicheren Abschaltung eines Solarmoduls 12, welches in den Strang 2 eingebettet ist.

Die Schaltvorrichtung 30a umfasst in der gezeigten unterbrechungsfrei arbeitenden Ausführung zunächst ein Relais 35 als Schaltmittel. Es fungiert als zweipoliger elektromagnetisch betätigter Einschalter zwischen den Kontakten B und C sowie den Kontakten E und F. In Fig. 3 ist der Zustand "Modul abgeschaltet" dargestellt, beide Verbindungen zum Solarmodul sind dabei unterbrochen. Ferner ist zur unterbrechungsfreien Brückung eine Diode 37 vorgesehen.

Die Diode 37 hat bei geöffnetem Einschalter-Kontakten B-C und E-F zwei Aufgaben: Erstens fließt der von den anderen Solarzellen erzeugte Strom durch die Diode ("Bypass"), der Solar-Stromkreis bleibt also geschlossen. Zweitens begrenzt sie die Spannung über den Relaiskontakten auf maximal etwa die Leerlaufspannung des Moduls.

Die grundsätzliche Arbeitsweise der Schaltvorrichtung 30 kann folgendermaßen zusammengefasst werden: Im Zustand "abgeschaltet" sind die Verbindungen von Kontakt B nach C und von Kontakt E nach F getrennt und das Modul ist aus der Reihenschaltung aller Module herausgenommen. Der von den anderen Solarzellen und Modulen erzeugte Strom fließt durch die Diode von D nach A; der Stromkreis des (Rest-)Stranges bleibt geschlossen und es ergibt sich keine Lücke im Strang.

Im Zustand "nicht abgeschaltet" sind die Verbindungen von Kontakt B nach C und von Kontakt E nach F geschlossen und das Modul ist mit den anderen Modulen in Reihe geschaltet; das ist der Normalbetrieb und das Modul liefert seinen Beitrag an Strom und Spannung des Stranges. Die Diode 37 sperrt und hat so keinen Einfluss.

Das Relais 35 ist mit einer Steuereinrichtung 40 verbunden, welches wiederum an die Stromversorgung 49 angeschlossen ist. Die vorgestellte Lösung funktioniert auch, wenn die Polarität von Modul und Diode umgekehrt wird.

In der unterbrechungsfrei arbeitenden Ausführung der Schaltvorrichtung 30a sind ein Schaltmittel und ein Halbleiterbauelement zur unterbrechungsfreien Brückung die wesentlichen Elemente.

Das Schaltmittel kann wie folgt ausgeführt sein als
● Mechanisch direkt betätigter Schalter
● Mechanisch indirekt betätigter Schalter, z.B. Nockenschalter in mechanischer Zeitschaltuhr
● Elektromagnetisch fernbetätigter Schalter, z.B. Relais, Schütz
● Elektronischer Schalter, z.B. Halbeiterrelais
● Eine Kombination aus mehreren Schaltern, um spezielle Anwendungsfälle zu ermöglichen, z.B. ein Relais für die zentrale Steuerung und ein Kippschalter für die Abschaltung direkt am Modul.

Vorteilhaft für alle Schaltmittel-Varianten ist die vergleichsweise geringe Spannung, unter der die Schaltvorgänge ausgeführt werden. In jedem Fall sind die Anforderungen an die verwendeten Bauteile und die Belastung der Bauteile im Betrieb niedrig, verglichen mit herkömmlichen DC-Schaltern.

Verzichtet man auf die vollständige galvanische Trennung des abgeschalteten Solarmoduls, so kann die Abschaltvorrichtung noch weiter vereinfacht werden, wie in Fig. 4 angedeutet ist. Figur 4 zeigt ein zweites konkretes Ausführungsbeispiel einer Schaltvorrichtung 30b zur sicheren einpoligen Abschaltung eines Solarmoduls 12, welches in den Strang 2 eingebettet ist.

Die Schaltvorrichtung 30b umfasst in der gezeigten unterbrechungsfrei arbeitenden Ausführung ein Relais 35 als Schaltmittel. Es fungiert als einpoliger elektromagnetisch betätigter Einschalter zwischen den Kontakten B und C. In Fig. 4 ist der Zustand "Modul abgeschaltet" dargestellt, die Verbindung zum Solarmodul ist dabei einseitig unterbrochen. Ferner ist zur unterbrechungsfreien Brückung eine Diode 37 vorgesehen. Die grundsätzliche Arbeitsweise ist so, wie schon bei der sicheren zweipoligen Abschaltung aus Fig. 3 erläutert.

Die einpolige Ausführung reicht für den Brandfall völlig aus, für den Wartungsfall hat die zweipolige Ausführung Vorteile, da damit eine vollständige galvanische Trennung des Moduls vom Strang erfolgt und am Modul kein Strangspannung-führendes Teil mehr vorhanden ist.

Die Steuerung 40 eines Schaltmittels oder der Schaltvorrichtungen 30a und 30b kann, wie bereits ausgeführt, zentral oder dezentral erfolgen.

Es sind u. a. folgende Steuervarianten vorteilhaft realisierbar:
1.) Die einfachste Form der Steuerung ist die direkte Verbindung aller einzelnen Abschaltvorrichtungen zu einem Netzteil für die Stromversorgung, das seinerseits an einer Phase des 230V-Hausnetzes angeschlossen ist, in die kein Solarstrom eingespeist wird.
   ● Im Normalbetrieb werden alle Abschaltvorrichtungen über das 230V-Stromnetz vom Energieversorgungsunternehmen mit Strom versorgt.
   ● Im Brandfall lässt die Feuerwehr das Gebäude stromlos schalten, dadurch werden die Abschaltvorrichtungen nicht mehr versorgt und schalten automatisch ihre Solarmodule aus dem Strang.
2.) Eine einfache Form der Steuerung für den Brandfall ist das Einschleifen einer oder mehrerer Temperatursicherungen in die Verbindung zwischen Stromversorgung und Abschaltvorrichtungen. Diese Sicherungen unterbrechen bei Übertemperatur den Versorgungsstromkreis und sorgen so für die Abschaltung.
3.) Eine weitere einfache Form der Steuerung, ideal als Vorkehrung für den Brandfall, ist das Einschleifen eines oder mehrerer Schalter (Öffner) in die Verbindung zwischen Stromversorgung und Abschaltvorrichtungen. Als Schalter bieten sich z.B. an
   ● Not-Aus-Schalter im Innenbereich
   ● Not-Aus-Schalter in wetterfester Ausführung im Außenbereich
   ● Reißleinenschalter
4.) Eine für die Wartung und Fehlersuche besonders geeignete Form der Steuerung ist die Möglichkeit, jede Abschaltvorrichtung einzeln zu steuern. Das kann auf einfache Weise durch einen Schalter pro Abschaltvorrichtung erfolgen. Durch Ab- und Zuschalten der einzelnen Module kann z.B. ein fehlerhaftes Modul im Strang schnell gefunden werden.
5.) Eine weitere Form ist die Steuerung über Sensoren (Helligkeit, Spannung, Temperatur etc.) oder Uhren (Jahreszeit, Tageszeit).
6.) Kombinationen aus den Möglichkeiten 1. bis 5.

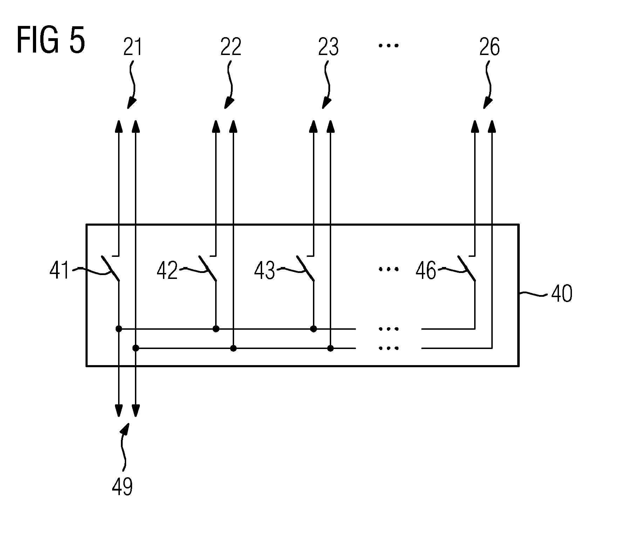

Fig. 5 zeigt den prinzipiellen Aufbau einer Steuerungseinrichtung 40 für Wartung und Fehlersuche. Diese besteht aus Schaltern 41, 42, 43 bis 46, die jeweils die Verbindung zwischen den sicheren Abschaltvorrichtungen 21, 22, 23 bis 26 und einer gemeinsamen Stromversorgung 49 herstellen oder unterbrechen. Mit jedem dieser Schalter 41 bis 46 kann das an die Abschaltvorrichtung angeschlossene Solarmodul (hier 11 bis 16, siehe Fig. 2) ab- oder zugeschaltet werden. Durch Ab-und Zuschalten der einzelnen Module kann z.B. ein fehlerhaftes Modul im Strang schnell gefunden werden.

Die Steuerung aus Fig. 5 ist außerdem auch für den Brandfall geeignet: Öffnet man alle Schalter, werden entsprechend alle Module abgeschaltet und Strangspannung ist 0 Volt. D.h. die Verbindung von den Solarmodulen auf dem Dach zur Gleichstrom-Freischaltstelle bzw. zum Netzeinspeisegerät im Haus ist komplett spannungsfrei.

## Patentansprüche

1. Photovoltaikanlage (1) mit mindestens einer Reihenschaltung (2) von Solarzellen,
**dadurch gekennzeichnet,**
**dass** die Anlage (1) derart ausgelegt ist, dass eine Aufteilung der Reihenschaltung (2) in kleinere Gruppen aus Solarzellen (11,12,13,14,15,16) erfolgt, so dass an jeder Gruppe höchstens eine ungefährliche Kleinspannung anliegt, wobei jede Gruppe ein Schaltmittel (35) aufweist, das derart ausgelegt ist, dass eine vorgegebene oder vorgebbare An- oder Abschaltung der Gruppe erfolgen kann.

2. Photovoltaikanlage (1) nach Anspruch 1,
**dadurch gekennzeichnet,**
**dass** das Schaltmittel (35) steuerbar ist.

3. Photovoltaikanlage (1) nach Anspruch 2,
**dadurch gekennzeichnet,**
**dass** als steuerbares Schaltmittel ein elektromagnetisch oder elektronisch betätigter Schalter vorgesehen ist.

4. Photovoltaikanlage (1) nach einem der Ansprüche 1 bis 3,
**dadurch gekennzeichnet,**
**dass** jede Gruppe (11,12,13,14,15,16) ein Mittel zur Brückung (37) aufweist, welches derart ausgelegt ist, dass während der Abschaltung der Gruppe eine Verbindung zwischen den in der Reihenschaltung verbleibenden Solarzellen besteht.

5. Photovoltaikanlage (1) nach Anspruch 4,
**dadurch gekennzeichnet,**
**dass** als Mittel zur Brückung (37) ein Halbleiter-Bauelement vorgesehen ist, um bei Abschaltung eine unterbrechungsfreie Verbindung zwischen den in der Reihenschaltung verbleibenden Solarzellen zu gewährleisten.

6. Photovoltaikanlage nach einem der vorhergehenden Ansprüche,
**dadurch gekennzeichnet,**
**dass** das Schaltmittel (35) und das Mittel zur Brückung (37) zu einer Schaltvorrichtung (30a, 30b) zusammengefasst sind.

7. Steuereinrichtung (40) für eine Photovoltaikanlage (1) gemäß einem der Ansprüche 1 bis 5,
**dadurch gekennzeichnet,**
**dass** eine zentrale Steuereinheit vorgesehen ist, welche mit mindestens einem der Schaltmittel (35) zum Abschalten einer Gruppe verbunden ist.

8. Steuereinrichtung (40) für eine Photovoltaikanlage (1) gemäß einem der Ansprüche 1 bis 5,
**dadurch gekennzeichnet,**
**dass** pro Gruppe von Solarzellen und Schaltmittel eine dezentrale Steuereinheit vorgesehen ist.

9. Steuereinrichtung (40) nach Anspruch 7 oder 8
**dadurch gekennzeichnet,**
**dass** ferner mindestens ein Sensor vorgesehen ist, welcher mit mindestens einer Steuereinheit verbunden ist, derart dass in Abhängigkeit von dem ermittelten Sensorsignal eine Abschaltung der zu steuernden Gruppe veranlasst wird.

10. Steuereinrichtung (40) nach einem der Ansprüche 6 bis 9,
**dadurch gekennzeichnet,**
**dass** ferner eine Zeitschaltuhr vorgesehen ist, mittels welcher eine Abschaltung der zu steuernden Gruppe veranlasst wird.

11. Steuereinrichtung nach einem der Ansprüche 6 bis 10,
**dadurch gekennzeichnet,**
**dass** mindestens ein weiteres Schaltmittel in die Verbindung zwischen einer Steuereinheit und dem Schaltmittel zum Abschalten einer Gruppe eingefügt ist.

12. Schaltvorrichtung (30) für eine Gruppe von Solarzellen einer Photovoltaikanlage (1) mit mindestens einer Reihenschaltung von Solarzellen, aufweisend ein steuerbares Schaltmittel (35), das derart ausgelegt ist, dass eine vorgegebene oder vorgebbare An- oder Abschaltung der Gruppe erfolgen kann, und
dass ferner zu jedem dieser Schaltmittel (35) mindestens ein Mittel zur Brückung (37) vorhanden ist, welches derart ausgelegt ist, dass während der Abschaltung der Gruppe eine Verbindung zwischen den in der Reihenschaltung verbleibenden Solarzellen besteht.
